# FASCICULE DE BREVET EUROPEEN

(11) **EP 2 628 243 B1**
(45) Date de publication et mention de la délivrance du brevet: **11.09.2019**
(21) Numéro de dépôt: 11764758.6
(22) Date de dépôt: 06.10.2011
(51) Int. Cl.: H03H 9/02, H03H 3/02, H03H 3/08

(54) **STRUCTURE ACOUSTIQUE HETEROGENE FORMEE A PARTIR D'UN MATERIAU HOMOGENE**
HETEROGENE AKUSTISCHE STRUKTUR AUS EINEM HOMOGENEN MATERIAL
HETEROGENOUS ACOUSTIC STRUCTURE FORMED FROM A HOMOGENEOUS MATERIAL

(30) Priorité: 15.10.2010 FR 1058402
(43) Date de publication de la demande: 21.08.2013
(73) Titulaire: Commissariat à l'Énergie Atomique et aux Énergies Alternatives, 75015 Paris (FR)
(72) Inventeur: REINHARDT, Alexandre, F-38400 Saint Martin d'Heres (FR)
(74) Mandataire: Esselin, Sophie
(86) Numéro de dépôt international: PCT/EP2011/067508
(87) Numéro de publication internationale: WO 2012/049073

(56) Documents cités:
- WO-A2-2007/072409
- JP-A- 10 084 248
- US-A1- 2008 303 876
- SAMARAO A K ET AL: "Temperature compensation of silicon micromechanical resonators via degenerate doping", ELECTRON DEVICES MEETING (IEDM), 2009 IEEE INTERNATIONAL, IEEE, PISCATAWAY, NJ, USA, 7 décembre 2009 (2009-12-07), pages 1-4, XP031644403, ISBN: 978-1-4244-5639-0

## Description

Le domaine de l'invention est celui des dispositifs acoustiques (résonateurs, filtres, mais aussi éventuellement les modulateurs acousto-optiques) réalisés à partir de matériaux piézoélectriques (LiNbO₃, LiTaO₃,...).

Les matériaux piézoélectriques monocristallins sont largement exploités dans l'industrie, notamment pour la réalisation de composants à ondes acoustiques de surface (SAW, pour *Surface Acoustic Wave*) ou à ondes acoustiques de volume (BAW, pour *Bulk Acoustic Wave*) permettant la synthèse de résonateurs ou de filtres. Pour ces applications, les substrats piézoélectriques les plus employés sont le quartz, le niobate ou le tantalate de lithium (LiNbO₃, LiTaO₃), voire la langasite. Parmi ces matériaux, le niobate et le tantalate de lithium présentent de plus de relativement fortes variations de l'indice optique en fonction des contraintes mécaniques, ce qui en fait des candidats de choix pour la réalisation de modulateurs acousto-optiques par exemple.

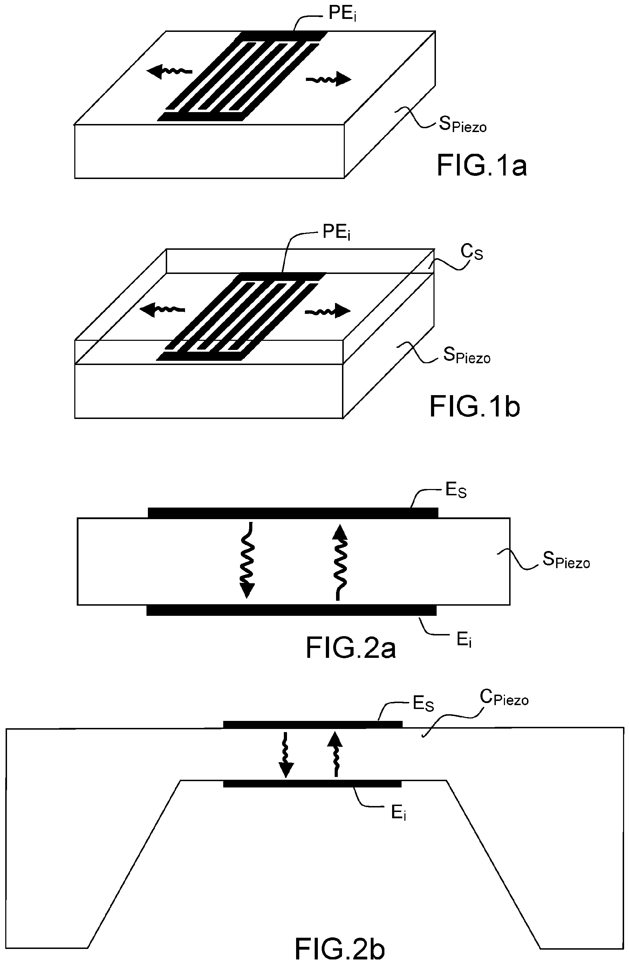

De part la nature massive des substrats précités, le milieu de propagation des ondes acoustiques ne peut être constitué que dudit substrat et d'une ou plusieurs couches supplémentaires éventuellement déposées. Ceci ne permet donc que l'exploitation d'ondes de surface (des ondes naturellement guidées à la surface du substrat), d'ondes guidées dans une couche déposée, ou d'une onde guidée à l'interface entre le substrat et une couche déposée. Dans tous ces cas, les composants réalisés exploitent des électrodes en forme de peignes interdigités, déposés à la surface du substrat, pour la génération ou la réception d'ondes acoustiques, voire les deux simultanément, comme représenté sur les figures 1a et 1b qui illustrent respectivement une configuration dans laquelle les ondes sont créées par des peignes P_{Ei} d'électrodes interdigitées réalisés directement à la surface d'un substrat piézoélectrique S_{piezo} ou à l'interface entre une couche Cs et un substrat piézoélectrique S_{piezo}.

L'avantage des composants à ondes de surface tels que ceux représentés sur les figures 1a ou 1b est que les ondes de surface sont essentiellement localisées dans le substrat, ce qui permet de tirer parti des propriétés des matériaux monocristallins : excellente reproductibilité des propriétés élastiques, diélectriques et piézoélectriques comparé à un matériau déposé, minimisation des pertes acoustiques grâce à l'absence d'inhomogénéités (joins de grains, dislocations, ...) dans le matériau.

L'inconvénient, par contre, est que malgré la possibilité de modifier l'orientation cristalline, la vitesse de propagation des ondes de surface reste imposée par le matériau composant le substrat, et reste généralement relativement faible (aux alentours de 4000 à 5000 m/s). Pour des applications à haute fréquence (quelques GigaHertz), les dimensions des motifs des électrodes deviennent extrêmement faibles, étant liées à la longueur d'onde du mode que l'on cherche à exciter, et deviennent donc difficiles à contrôler technologiquement. Le même problème est rencontré dans le cas des ondes d'interface.

Une solution à cette diminution des dimensions des peignes interdigités consiste à utiliser des ondes présentant une vitesse de propagation supérieure à celle des ondes de surface. C'est le cas d'ondes guidées dans une couche déposée à la surface du substrat. De telles ondes peuvent en théorie atteindre des vitesses de propagation virtuellement infinies. Plus raisonnablement, il est possible d'exploiter des ondes possédant des vitesses de phase de l'ordre de quelques dizaines de kilomètres par seconde, ce qui permet déjà, à fréquence égale, de relâcher considérablement les contraintes sur la définition des motifs des électrodes.

L'inconvénient majeur dans ce cas est que ces ondes sont essentiellement localisées dans la couche reportée. Ceci a deux conséquences : premièrement, l'onde se propage dans un milieu qui ne possède plus un caractère monocristallin, et présente par conséquent des pertes supérieures à une onde de surface, même si un confinement parfait de ces ondes est supposé. Deuxièmement, la transduction (conversion d'énergie électrique en énergie mécanique et vice versa) s'effectue dans le matériau piézoélectrique, même si l'essentiel de l'énergie acoustique est localisé dans la couche déposée. Il s'en suit donc que l'efficacité de cette transduction est considérablement réduite, ce qui se traduit par une diminution des performances du composant final (filtres à bandes passantes plus étroites, résonateurs présentant des résonances moins marquées, ...).

Il est également possible d'exploiter des ondes dites de volume, se propageant, elles, dans la direction de l'épaisseur du substrat. Ces ondes sont excitées par des électrodes, une électrode dite supérieure E_{S} et une électrode dite inférieure Ei entourant le substrat piézoélectrique S_{piezo}, comme représenté par exemple sur la figure 2a. La fréquence de résonance est dans ce cas directement reliée à l'épaisseur de la plaque piézoélectrique. Pour des applications à basse fréquence (quelques MegaHertz), les épaisseurs des substrats, typiquement de l'ordre de 300 à 500 µm, conviennent.

A des fréquences plus élevées, il devient nécessaire de réduire les épaisseurs, jusqu'à quelques centaines de nanomètres pour des applications à des fréquences de l'ordre du GigaHertz. Cela peut être obtenu par une gravure locale du substrat de manière à former une membrane d'épaisseur désirée comme illustré en figure 2b qui montre le substrat aminci en une couche piézoélectrique C_{piezo}, les ondes étant excitées par une électrode supérieure Es et une électrode inférieure Ei. Cette technique est couramment employée pour les résonateurs à quartz, mais difficile à appliquer à des matériaux tels que le LiTaO₃ ou le LiNbO₃, en raison de leur très grande résistance aux diverses techniques de gravure chimique ou physique.

De plus, en raison de la précision requise sur les épaisseurs à obtenir, les approches d'amincissement local ont été historiquement abandonnées. On préfère actuellement recourir à des techniques de dépôt de couches minces piézoélectriques, qui présentent des homogénéités et des contrôles d'épaisseur bien meilleures. On nomme les composants ainsi réalisés FBAR (pour *Film Bulk Acoustic Resonator*) lorsque l'on forme une membrane piézoélectrique suspendue, ou SMR (pour *Solidly Mounted Resonator*) lorsque le confinement acoustique est obtenu par l'utilisation d'un miroir composé de couches multiples empilées (analogue aux miroirs de Bragg optiques). Même si ces composants connaissent depuis les dix dernières années un essor considérable, ils présentent toutefois plusieurs inconvénients majeurs :
- les techniques de dépôt de couches piézoélectriques ne permettent pas un choix aisé de l'orientation cristalline du matériau. En pratique, une seule orientation est donc possible, ce qui impose aux ondes exploitées des caractéristiques précises (polarisation, vitesse de propagation, ...) ;
- les propriétés des matériaux piézoélectriques habituellement employés pour ce type de composants, à savoir le nitrure d'aluminium (AlN) ou l'oxyde de zinc (ZnO) sont très inférieures à celles des matériaux employés pour les applications d'ondes de surface (LiNbO₃ ou LiTaO₃), ce qui ne permet pas la synthèse de filtres à très large bande, de résonateurs à très forts coefficients de surtension, etc...

Plus récemment, des techniques de transfert de couches minces, telles que par exemple des combinaisons de collage / amincissement ou même le procédé Smart Cut concernant le LiNbO₃ comme décrit dans l'article M. Pijolat, A. Reinhardt, E. Defay, C. Deguet, D. Mercier, M. Aïd, J-S Moulet, B. Ghyselen, D. Gachon, S. Ballandras « Large Q.f product for HBAR using SmartCut transfer of LiNbO3 thin layers onto LiNbO3 substrate. »-Proceedings of the 2008 IEEE Ultrasonics Symposium, p201-204 ont permis de former de fines couches piézoélectriques monocristallines (quelques centaines de nanomètres) reportées sur d'autres substrats, tout en conservant les propriétés intrinsèques du matériau d'origine. Une partie des inconvénients mentionnés plus haut peuvent donc être résolus par ces techniques. Néanmoins, les procédés utilisés imposent des contraintes technologiques qui restent à l'heure actuelle encore incontournables :
- le substrat dit « hôte » (le substrat du composant final) et le substrat dit « donneur » (celui d'où provient la couche reportée) doivent pouvoir être collés l'un sur l'autre. Ils doivent donc être tous les deux plans. Ils doivent également présenter des surfaces compatibles avec le collage ;
- en raison des coefficients de dilatation différents entre la couche reportée et le substrat hôte, tous les types de collage ne sont pas toujours possibles, surtout si l'on ne désire pas recourir à une couche élastique pouvant absorber les dilatations différentielles. Ainsi, pour des couches de LiNbO₃, il est difficile d'effectuer un report sur un substrat silicium, et on préfère reporter une couche de LiNbO₃ sur un substrat du même matériau pour s'affranchir de ces phénomènes. Cette contrainte réduit fortement les possibilités d'empilements possibles, et se révèle à l'heure actuelle un frein à la fabrication de dispositifs SMR utilisant des couches reportées.

Dans ce contexte, la présente invention propose une solution permettant de résoudre notamment les problèmes liés à l'utilisation de couches monocristallines, que ce soit pour des applications de type SAW, BAW, ou même pour des couches reportées et plus généralement propose une solution permettant de réaliser des structures acoustiques dont les propriétés acoustiques peuvent être modifiées voire optimisées grâce à l'introduction d'espèces implantées dans le volume de ladite structure, en modifiant le module d'Young et/ou la densité.

Il est connu que l'implantation d'atomes divers dans un matériau conduit à des modifications de ses propriétés optiques, principalement l'indice du milieu. Ce principe a été abondamment appliqué et testé sur une grande variété de substrats comme décrit dans l'article de G. Destefanis, J.P. Gaillard, E.L. Ligeon, S. Valette, B.W. Farmery, P.D. Townsend, A. Perez, The formation of waveguides and modulators in LiNbO3 by ion implantation, J. Appl. Phys. 50 (12) p. 7898, 1979. Plus généralement, l'implantation se traduit par divers effets possibles, dépendant de l'espèce implantée, du matériau vers lequel s'effectue l'implantation, de l'énergie d'implantation, de la dose implantée et des différents recuits appliqués, ces effets pouvant être :
- la formation de lacunes électroniques et/ou de défauts dans le cristal d'origine, provoquant une modification des propriétés électroniques, et donc des propriétés optiques du milieu ;
- la substitution d'une partie des atomes du milieu par des atomes implantés. Ceci se traduit par la formation localement d'un nouveau composé, différent du matériau d'origine, entraînant une nouvelle fois une modification de l'indice optique ;
- la précipitation de l'espèce implantée, de manière à former des inclusions de taille nanométrique. En fonction de l'espèce implantée, ces inclusions peuvent apparaître comme des bulles de gaz (implantation d'Hydrogène ou d'Hélium, par exemple) ou comme des inclusions solides (implantation de Carbone ou de Titane, par exemple).

Si le premier effet n'a a priori que peu ou pas d'influence sur les propriétés mécaniques du milieu, les deux autres, au contraire, modifient les conditions de propagation d'une onde acoustique.

De manière similaire, il est connu que des réactions chimiques peuvent entraîner la substitution d'atomes du cristal par des atomes provenant d'une source extérieure et pénétrant dans le milieu piézoélectrique par diffusion. Le cas le plus classique est par exemple l'échange protonique, ou des atomes d'hydrogène, apportés par un bain acide, se substituent à des atomes de lithium dans le niobate de lithium (LiNbO₃) pour former de l'acide niobique (HNbO₃) ou un composé de type HNbO₃. Ce cas est par exemple décrit dans l'article J.L. Jackel, C.E. Rice, J.J. Veselka, Proton exchange for high-index waveguides in UNbO3, Applied Physics Letters vol. 41, n°7, p. 607, 1982. Pour ce type de réactions, un effet identique à la substitution discutée ci-dessus se produit, et permet donc de modifier localement les propriétés acoustiques du milieu. La différence par rapport à une substitution par implantation est que ce type de procédés ne permet la modification du matériau d'origine que près de la surface. Toutefois, comme indiqué dans l'article précité, cette modification peut s'étendre très profondément (une dizaine de microns) dans le milieu d'origine, contrairement aux techniques d'implantation où les inclusions seront certes non connectées à la surface de l'échantillon mais seront localisées à des profondeurs limitées par l'énergie d'implantation, typiquement de l'ordre de quelques microns.

Le principe de la présente invention consistant à implanter ou à venir faire diffuser des espèces est particulièrement pertinent dans le cas de matériau cristallin afin de modifier localement les propriétés mécaniques d'un milieu de manière à former de nouvelles structures de composants acoustiques. Il est tout aussi intéressant de manière plus générale dans tout type de matériau afin de modifier les propriétés élastiques des matériaux en en modifiant les caractéristiques élastiques.

De manière alternative, la formation d'inclusions dans le matériau d'origine peut également être exploitée. Ces inclusions étant bien plus petites que la longueur d'onde acoustique pour des fréquences inférieures à quelques dizaines de GigaHertz (quelques dizaines de nanomètres contre quelques microns ou quelques centaines de nanomètres), elles ne provoquent pas de réfraction des ondes mais permettent plutôt à ces dernières de se comporter comme si elles se propageaient dans un milieu équivalent dont les propriétés se situent entre celles du matériau d'origine et celles des inclusions.

Le document JP10084248 décrit une structure acoustique comprenant un matériau piézoélectrique aux propriétés modifiées par diffusion de chlore.

Ainsi la présente invention a pour objet une structure acoustique telle que définit par la revendication indépendante 1.

L'invention a aussi pour objet un procédé de fabrication d'une structure acoustique tel que définit par la revendication indépendante 9.

L'invention sera mieux comprise et d'autres avantages apparaîtront à la lecture de la description qui va suivre donnée à titre non limitatif et grâce aux figures annexées parmi lesquelles :
- les figures 1a et 1b illustrent respectivement un composant à ondes de surface exploitant, pour l'excitation ou la détection des ondes, des peignes directement déposés sur la surface et des peignes recouverts par une couche déposée à la surface du substrat ;
- les figures 2a et 2b illustrent un composant à ondes de volume utilisant respectivement un substrat piézoélectrique massif et un substrat piézoélectrique aminci ;
- la figure 3 illustre une première variante de l'invention de résonateur à ondes de volume comportant une zone implantée constitutive d'une sous-structure de miroir de Bragg ;
- la figure 4 illustre le profil de concentration d'un matériau implanté en fonction de la profondeur ;
- la figure 5 illustre un profil de concentration de concentration plus évasé par superposition de profils individuels centrés autour de profondeurs différentes h₁ et h₂ ;
- la figure 6 illustre un profil de concentration périodique aux profondeurs h₁, h₂, h₃ et h₄ permettant de réaliser une sous-structure de miroir de Bragg ;
- les figures 7a à 7d illustrent les différentes étapes d'un procédé de fabrication du résonateur illustré en figure 3 ;
- la figure 8a illustre une vue de dessus d'un résonateur de type LFE acronyme de « Lateral Field Excitation », à excitation par un champ latéral, et la figure 8b illustre une vue de dessus d'un résonateur à ondes guidés ;
- la figure 9 illustre une vue de dessus d'un exemple de filtre à couplage acoustique latéral par couplage à travers un cristal phononique tridimensionnel ;
- la figure 10 illustre une vue en coupe d'un exemple de filtre comportant des résonateurs couplés latéralement, dont le couplage est optimisé grâce à la présence de secondes zones implantées de second module d'Young et/ou de seconde densité ;
- les figures 11a à 11e illustrent les étapes d'un exemple de procédé permettant de réaliser un exemple de filtre utilisant des résonateurs de type LFE et comprenant des cristaux phononiques tridimensionnels et une sous-structure de miroir de Bragg, selon l'invention ;
- les figures 12a à 12e illustrent les étapes d'un exemple de procédé permettant de réaliser un exemple de filtre comprenant une structure de miroir de Bragg intégrée ;
- la figure 13 illustre un exemple de composant exploitant des ondes guidées le long d'une interface formée par implantation d'atomes dans le milieu de propagation à une profondeur donnée, selon l'invention ;
- les figures 14a à 14c illustrent les étapes d'un procédé permettant de réaliser la structure de guide d'onde implanté et représenté en figure 13.

De manière générale, la structure élastique de la présente invention comporte ainsi au sein d'une couche de matériau de premier module d'Young et/ou de première densité, au moins une zone dans laquelle ce dit module d'Young et/ou cette dite densité sont modifiés par implantation atomique ou par diffusion d'espèces chimiques de manière à disposer d'une couche présentant au moins localement un second module d'Young et/ou une seconde densité de manière à pouvoir bénéficier de propriétés mécaniques, voire électro-mécaniques adaptées pour notamment des applications en propagation acoustique.

Ainsi, selon l'invention, la possibilité de modifier les propriétés élastiques et donc notamment acoustiques, permet par exemple de manière simple de former des structures analogues à des structures multicouches habituellement rencontrées (guides d'ondes acoustiques, miroirs de Bragg, ...), sans toutefois nécessiter le dépôt de nombreuses couches.

La flexibilité des techniques d'implantation (choix des espèces implantées et de l'énergie d'implantation) ou de diffusion (choix de la source des espèces diffusées, température et durée de la réaction) permet de modifier le milieu d'origine de manières différentes (inclusions d'hydrogène, d'hélium, de carbone ou formation d'un nouveau composé) à différentes profondeurs et sur différentes épaisseurs. Ceci permet non seulement d'envisager la formation de structures périodiques, mais également des structures hautement hétérogènes.

Enfin, l'implantation ou la réaction de diffusion peuvent être effectuées à travers un système de masques (en résine ou dans un autre matériau qui empêche la pénétration des espèces implantées ou diffusées), ce qui permet de ne former les structures précitées qu'à l'intérieur de motifs prédéfinis. Il devient alors possible de former des structures tridimensionnelles en combinant plusieurs masquages et plusieurs implantations et/ou diffusions différentes.

En combinant des structures acoustiques classiques à des zones modifiées localement, on peut concevoir des structures particulièrement intéressantes dont certaines sont décrites ci-après de manière non exhaustives.

### Exemple de structure de résonateurs à ondes élastiques de volume de type SMR :

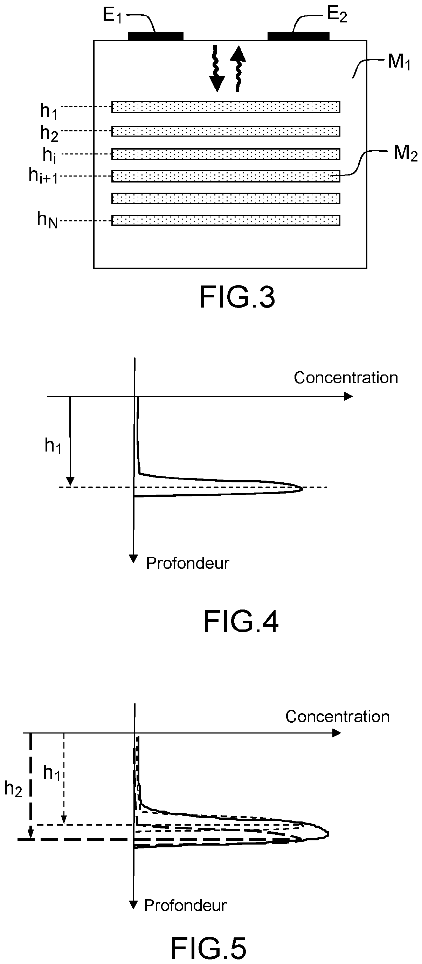

De manière générale, un résonateur à ondes de volume de type « SMR », comporte une couche épaisse de matériau piézoélectrique, deux électrodes supérieures et une sous-structure de miroir de Bragg. La figure 3 illustre un résonateur selon la présente invention de type SMR, dans lequel la structure de miroir de Bragg est matérialisée par des couches enterrées réalisée par implantation atomique. Plus précisément, au sein d'un matériau M₁ de premier module d'Young et/ou de première densité, on réalise par implantation des couches de matériau M₂ présentant un second module d'Young et/ou de seconde densité, lesdites couches étant réalisées à des profondeurs respectivement h₁, h₂, ..., h_{N}, la distance entre une profondeur hᵢ et une profondeur hᵢ₊₁ étant égale par exemple à une demi longueur d'onde, pour assurer à l'ensemble de l'empilement des couches une sous-structure de miroir de Bragg, deux électrodes supérieures E₁ et E₂ étant réalisées à la surface du matériau de premier module d'Young.

Selon la présente invention, une sous-structure de miroir de Bragg peut être réalisée relativement facilement dans un substrat de niobate de lithium. Dans ce cas particulier, l'implantation d'hydrogène peut entraîner une réaction de substitution entre les atomes de lithium et les atomes implantés. Il se forme ainsi une phase HₓLi₍₁₋ₓ₎NbO₃ dont les propriétés mécaniques sont sensiblement différentes de celles du niobate de lithium d'origine.

La figure 4 illustre le profil de concentration d'un matériau implanté dans une structure élastique selon l'invention, et met en évidence qu'il est possible de définir à une profondeur h₁, une couche de matériau de second module d'Young avec une dose d'implantation suffisante.

On obtient ainsi un profil de propriétés acoustiques (élasticité et densité) semblable (ou inversé) à ce profil de concentration. A titre d'exemple, l'implantation d'Hydrogène dans du Niobate de Lithium permet d'obtenir une épaisseur de 130 nm pour une dose de 8.10¹⁶ atomes/cm², ou de 202 nm pour une dose de 1.3.10¹⁵ atomes/cm².

Ainsi, pour éventuellement élargir ce profil, plusieurs implantations à des énergies différentes permettent de former un profil plus évasé par superposition de profils individuels centrés autour de profondeurs différentes h₁ et h₂, comme représenté sur la figure 5.

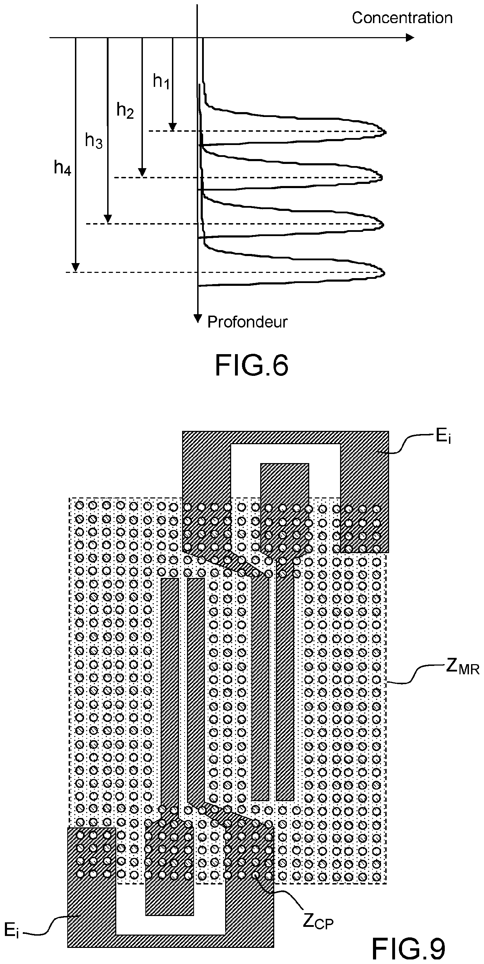

En répétant cette opération plusieurs fois à des énergies différentes, on obtient un profil de concentration périodique aux profondeurs h₁, h₂, h₃ et h₄, comme représenté sur la figure 6. Ceci se traduit par une variation périodique des propriétés acoustiques et forme un miroir de Bragg réfléchissant les ondes acoustiques. Un ajustement des largeurs de profils et de leur périodicité permet d'obtenir un miroir acoustique opérant à la fréquence désirée. La transmission de ce miroir est, elle, déterminée par le nombre de périodes réalisées. Il est à remarquer que pour cette application, de forts gradients de propriétés acoustiques, et donc de concentration en espèce implantée, ne sont pas absolument nécessaires, puisque c'est la périodicité de la structure qui entraîne l'effet de réflexion des ondes. On peut donc compenser un faible contraste acoustique entre le matériau d'origine et la nouvelle phase formée par un grand nombre d'implantations différentes.

Il est à noter que ces implantations sont tout à fait réalisables à travers un masque, ce qui permet de ne définir le miroir qu'au niveau du résonateur et de laisser le matériau d'origine intact partout ailleurs.

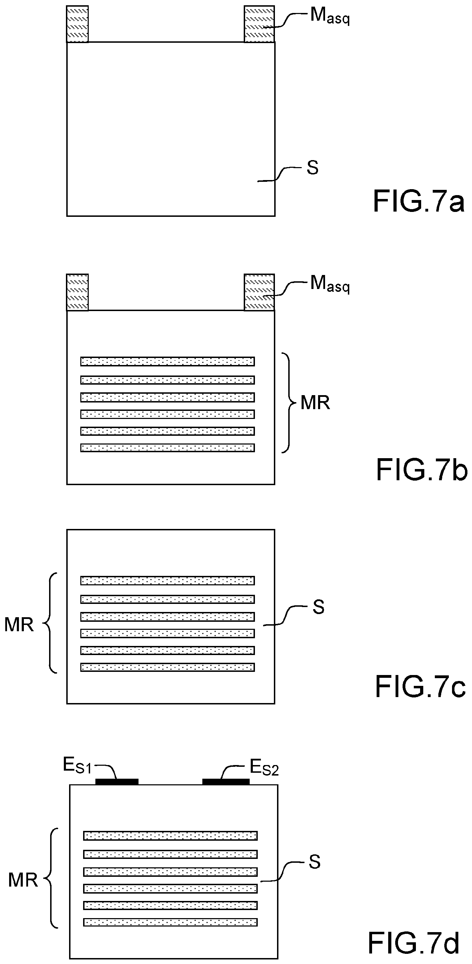

Un exemple de procédé est décrit ci-après grâce aux figures 7a à 7d.
- A partir d'un substrat de niobate de lithium S, préalablement nettoyé, on procède à une opération de photolithographie pour définir un masque M_{asq} à l'implantation comme illustré en figure 7a ;
- on réalise comme illustré en figure 7b, des opérations d'implantations d'hydrogène successives par énergie décroissante, afin de former un profil d'implantation périodique tel que celui illustré en figure 6 et permettant de définir une sous-structure de miroir de Bragg MR ;
- on procède alors au retrait du masque de résine M_{asq} come illustré en figure 7c, et à une étape de recuit d'homogénéisation ;
- on procède enfin comme illustré en figure 7d, au dépôt de métal puis d'une autre couche de résine de masquage, à une opération de photolithographie, à la gravure et au retrait de résine pour définir les électrodes supérieures Es₁ et Es₂, par exemple en aluminium.

Les électrodes peuvent prendre la forme de deux électrodes en vis-à-vis pour un LFE, ou de peignes interditigités pour des ondes guidées.

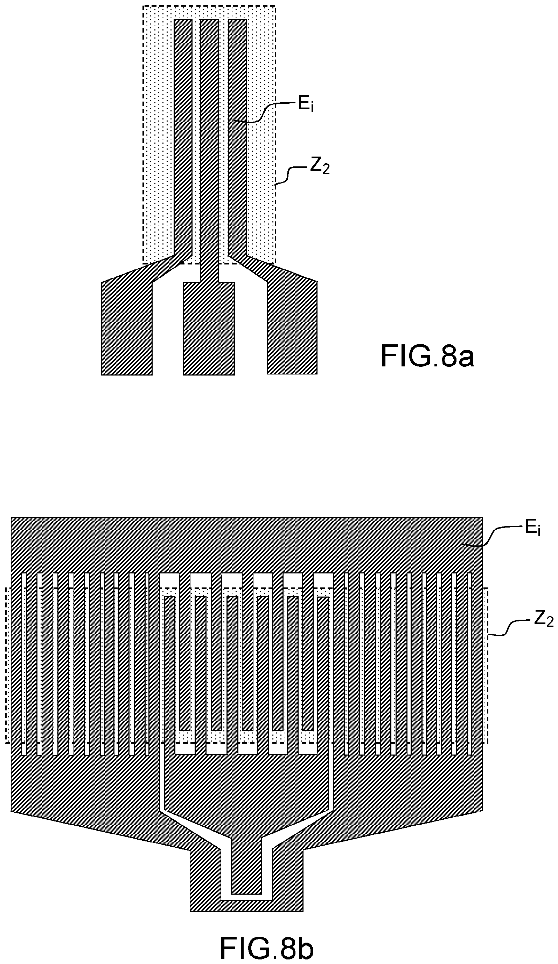

Les figures 8a et 8b illustrent des vues de dessus d'un exemple de résonateur de type LFE avec ses électrodes supérieures Ei et sa zone d'implantation Z₂ correspondant au matériau de second module d'Young et/ou de seconde densité.

De manière générale, dans un résonateur de type SMR, une fois la structure de miroir formé, on obtient naturellement une cavité acoustique résonante localisée entre la surface du substrat et le sommet du miroir. Sur un substrat de niobate de lithium coupe Z, des ondes acoustiques de cisaillement se propageant verticalement dans cette cavité sont générées par effet piézoélectrique par application d'un champ électrique horizontal. Ce champ est obtenu par la formation par exemple de deux électrodes déposées côte à côte, de manière à former un résonateur LFE, à excitation par champ électrique latéral.

L'implantation d'hydrogène n'entrainant que peu de défauts en dehors de la zone implantée, la piézoélectricité du matériau d'origine n'est que très peu affectée. Ce type de résonateur présente donc des coefficients de couplage électromécanique (mesure de l'efficacité de conversion énergétique de la forme électrique à mécanique, et réciproquement) de l'ordre de 56 %, à des fréquences de l'ordre de 5 GHz.

A titre de comparaison, les technologies habituelles de résonateurs piézoélectriques (SMR) basées sur des films minces déposés de nitrure d'aluminium ne permettent d'obtenir que des coefficients de couplage piézoélectriques de l'ordre de 6 % aux mêmes fréquences. Un composant tel que celui décrit ici permet donc d'ouvrir par exemple la voie à la synthèse de filtres extrêmement large bande tout en utilisant une technologie relativement simple.

Avec une technologie identique, si l'on remplace les électrodes des résonateurs à ondes de volume par des métallisations en forme de peignes interdigités comme illustré en figure 8b, il devient possible d'exploiter des ondes se propageant latéralement, elles-aussi confinées par un miroir acoustique formé d'une alternance de profils d'implantation différents.

### Exemple de structure de cristaux phononiques tridimensionnels

Les cristaux phononiques sont des analogues élastiques aux cristaux photoniques. Il s'agit d'agencements bi ou tridimensionnels d'inclusions dans une matrice solide. Les effets de périodicité permettent alors la formation de « bandes interdites » dans lesquelles la propagation d'ondes est fortement modifiée voire impossible. Des agencements bidimensionnels sont réalisables par la gravure d'ouvertures dans le milieu de propagation, et éventuellement leur remplissage par un matériau différent. A l'heure actuelle, la formation de réseau tridimensionnel à des échelles micro ou nanométriques en utilisant des techniques classiques de la microélectronique reste difficile.

La présente invention permet, par une combinaison de techniques d'implantation à différentes épaisseurs, comme pour le cas des miroirs de Bragg décrits précédemment, et de masquages (pour définir des motifs bidimensionnels), de former des structures tridimensionnelles Z₂ au sein d'un matériau Z₁. Pour cette application, les inclusions peuvent être obtenues par des effets de substitution ou de précipitation.

De tels cristaux peuvent être réalisés pour former des structures de guides d'onde ou de lentille acoustique par exemple.

La technique de fabrication de ces cristaux reprend les étapes de procédé précédemment décrites et illustrées grâce aux figures 7a à 7c.

Un tel cristal peut par exemple être utilisé en conjonction avec des résonateurs pour offrir un confinement latéral des ondes générées dans la cavité résonante, ce qui permet d'améliorer le coefficient de qualité du composant final dans le cas d'application de type filtre.

En effet, selon l'art connu une catégorie de filtres intéressants utilise des résonateurs couplés encore couramment dénommés CRF acronyme de « Coupled Resonator Filter »

Plus précisément, des filtres acoustiques sur quartz, dits monolithiques, utilisent un couplage latéral entre résonateurs. Dans ce cas les résonateurs sont placés côte-à-côte. On excite alors des ondes de cisaillement d'épaisseur (TS ou Thickness Shear) qui sont naturellement évanescentes en-dehors des résonateurs, et en faisant varier la distance entre les résonateurs on peut faire varier l'énergie transmise et ainsi modifier la largeur de la bande passante du filtre. Le filtre est alors appelé filtre à couplage latéral ou filtre monolithique.

La figure 9 illustre ainsi une vue de dessus d'un exemple de filtre à couplage acoustique latéral par couplage à travers un cristal phononique tridimensionnel, mettant en évidence les zones d'implantation constitutives de la sous-structure de miroir de Bragg Z_{MR} et les zones d'implantation constitutives du cristal phononique Z_{CP} avec les électrodes supérieures Ei.

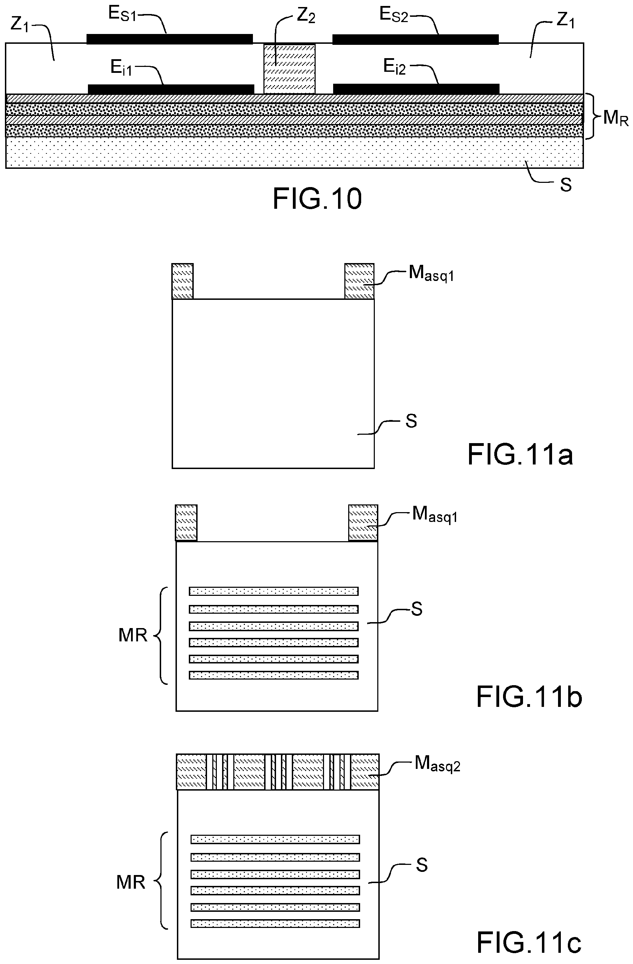

La figure 10 illustre à ce titre un exemple de filtre comportant des résonateurs couplés latéralement, dont le couplage est optimisé grâce à la présence de zone implantée. Plus précisément, les résonateurs couplés sont réalisés à partir d'une couche de matériau piézoélectrique définissant une première zone Z₁ de premier module d'Young, inséré entre des électrodes supérieures E_{S1} et E_{S2} et des électrodes inférieures Eᵢ₁ et Eᵢ₂, ces dernières étant réalisées à la surface d'un substrat S. Le couplage entre résonateurs est optimisé grâce à la présence d'une seconde zone Z₂ réalisée par implantation atomique permettant d'ajuster les propriétés acoustiques de ladite zone et réaliser une sous-structure de miroir de Bragg MR réalisée par implantation atomique.

Nous allons décrire ci-après plus en détails et grâce aux figures 11a à 11e un exemple de procédé de fabrication permettant de réaliser un résonateur de SMR avec couplage latéral et structure de miroir intégrée.

Selon un premier exemple et comme illustré en figure 11a, on procède à une opération de nettoyage d'un substrat S de Niobate de Lithium, suivie d'une opération de photolithographie pour définir un premier masque M_{asq1} destiné à couvrir des les zones implantées d'une structure de miroir de Bragg.

On procède comme illustré en figure 11b, à des opérations successives d'implantations d'hydrogène, par énergie décroissante, afin de former un profil d'implantation périodique pour obtenir la structure de miroir de Bragg MR.

On procède comme illustré en figure 11c, au retrait du masque de résine, puis à une nouvelle opération de photolithographie pour définir le second masque d'implantation M_{asq2}, afin de définir des zones de motifs constitutifs du cristal phononique Z_{CP}.

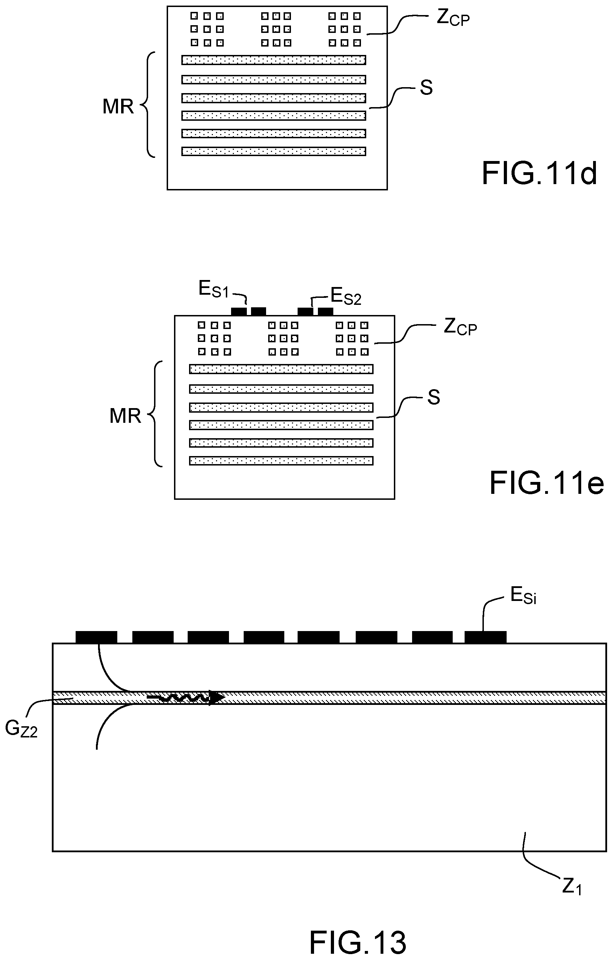

Comme illustré en figure 11d, on procède alors à des implantations d'hydrogène successives, par énergie décroissante, afin de former un profil d'implantation périodique, au travers du masque M_{asq2}, puis en opérant le retrait de ce dernier et en procédant à une opération de recuit d'homogénéisation.

On peut enfin procéder au dépôt d'une couche métallique, à une opération de photolithographie, à la gravure et au retrait de la résine pour définir les électrodes supérieures Es₁ et Es₂, par exemple en aluminium, comme illustré en figure 11e.

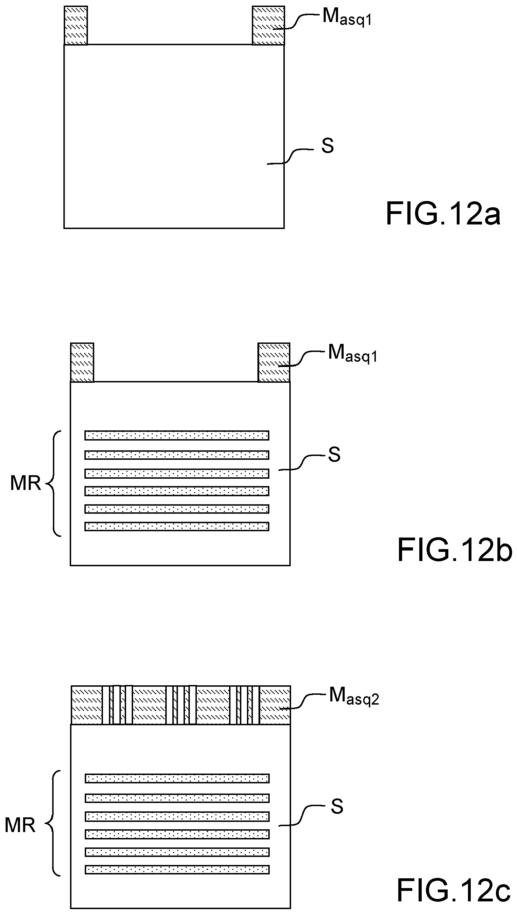

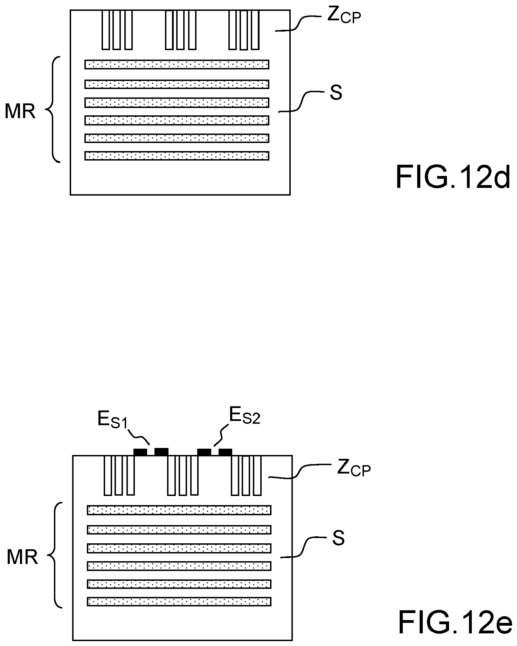

Une structure équivalente peut être obtenue en utilisant uniquement un cristal phononique bidimensionnel localisé entre les résonateurs que l'on désire coupler acoustiquement. La structure bidimensionnelle du cristal phononique est réalisée par le procédé d'échange protonique décrit plus haut. En ce qui concerne la réalisation du miroir de Bragg et des électrodes, la réalisation est identique à l'exemple précédent. Les étapes technologiques permettant la fabrication de ce type de structures sont décrites par exemple dans les figures suivantes :
Comme illustré en figure 12a, on procède au nettoyage d'un substrat S piézoélectrique de Niobate de Lithium puis à une opération de photolithographie pour définir un premier masque M_{asq1} couvrant les zones implantées.

Puis on procède à des opérations d'implantations d'hydrogène successives, par énergie décroissante, afin de former un profil d'implantation périodique, constitutif du miroir de Bragg MR, comme illustré en figure 12b.

On réalise ensuite le retrait du masque de résine par une nouvelle opération de photolithographie pour définir le second masque M_{asq2} à l'échange protonique comme illustré en figure 12c.

On effectue alors l'échange protonique par immersion dans un bain d'acide benzoïque (C₆H₅COOH) fondu (à une température supérieure à 249°C). Rinçage à l'alcool. Retrait de résine, permettant de définir des structures de cristal phononiques Z_{CP}.

On procède enfin aux opérations suivantes : dépôt, photolithographie, gravure et retrait de résine pour définir les électrodes supérieures Eₛ₁ et Eₛ₂, par exemple en aluminium, comme illustré en figure 12e.

Selon cette variante chaque résonateur comporte un couple d'électrodes supérieures Eₛ₁ et Eₛ₂ à la surface du matériau piézoélectrique, les électrodes au sein d'un même couple étant très proches, typiquement séparées de moins de quelques microns, les ondes acoustiques étant toujours propagées dans le volume du matériau piézoélectrique mais générées par un champ électrique parallèle au plan dudit matériau.

### Exemple de structure de guide d'onde enterré

Une troisième application possible de l'invention consiste à former un composant exploitant des ondes guidées le long d'une interface. Une telle interface est formée par implantation d'atomes dans le milieu de propagation à une profondeur donnée, permettant ainsi de définir un guide G_{z2} comprenant ladite zone de second module d'Young au sein d'un matériau correspondant à la zone Z₁ de premier module d'Young et/ou de première densité. Si ces atomes sont implantés en quantité suffisante, ils précipitent et forment des nano-inclusions de gaz localisés sur une même ligne. Localement, le long d'une fine ligne, il se forme alors un milieu équivalent présentant des vitesses de propagation inférieures à celles du milieu ambiant. Des ondes peuvent alors de propager le long de cette interface tout en restant guidées par elle (car elles sont évanescentes dans le matériau d'origine), comme représenté sur la figure 13, grâce à la présence d'électrodes de surface Esᵢ.

Le composant lui-même est donc réalisé selon le procédé suivant comprenant les étapes suivantes :
- l'implantation d'atomes le long de la ligne de guidage désirée ;
- le recuit de précipitation ;
- le dépôt et la structuration d'électrodes (par exemple en aluminium) en forme de peignes interdigités à la surface du substrat.

Il est à noter qu'il est également possible de réaliser cette interface par une implantation visant à provoquer une substitution.

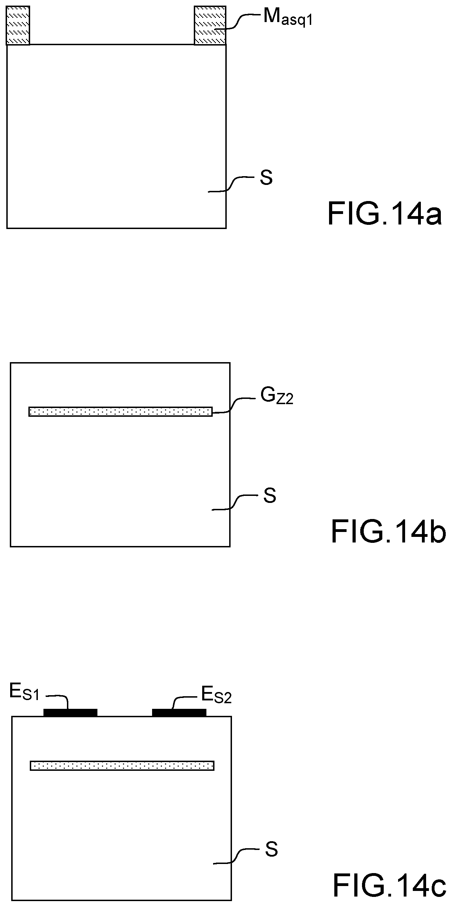

Les figures 14a à 14c illustrent à cet égard un exemple de procédé permettant d'obtenir un tel guide d'onde enterré.

Comme illustré en figure 14a, on procède au nettoyage d'un substrat S de Niobate de Lithium, puis à une opération de photolithographie pour définir un masque à l'implantation M_{asq}.

On réalise alors comme illustré en figure 14b, une opération d'implantation d'hélium à la profondeur à laquelle on désire réaliser l'interface guidante G_{Z2}.

On procède au retrait du masque de résine et à l'opération de précipitation.

On procède enfin comme illustré en figure 14c, au dépôt d'une couche métallique, à une opération de photolithographie, à la gravure et au retrait de résine pour définir les électrodes supérieures Es₁ et Es₂, par exemple en aluminium.

## Revendications

1. Structure acoustique comprenant :
- une couche de matériau piézoélectrique (Z1) comportant un premier ensemble d'atomes présentant un premier module d'Young dit intrinsèque et une première densité dite intrinsèque ;
- des électrodes situées en contact de la surface de ladite couche de matériau piézoélectrique pour générer une propagation d'ondes acoustiques au niveau de ladite couche ladite couche comportant :
au moins une seconde zone (Z2, Z_{CP}) n'étant pas en contact avec lesdites électrodes :
∘ enterrée dans le volume de ladite couche de matériau ;
∘ comprenant un second ensemble d'atomes comprenant ledit premier ensemble d'atomes plus des seconds atomes ou le second ensemble d'atomes comprenant ledit premier ensemble d'atomes dans lequel des seconds atomes sont en substitution de certains premiers atomes ;
∘ présentant un second module d'Young et /ou une seconde densité tel(le) qu'il (elle) modifie la propagation desdites ondes acoustiques.

2. Structure acoustique selon la revendication 1, **caractérisée en ce que** ladite seconde zone comprend :
- des lacunes électroniques et/ou de défauts dans le matériau piézoélectrique ou ;
- la substitution d'une partie des atomes du matériau piézoélectrique par des atomes implantés ou ;
- des inclusions.

3. Structure acoustique selon l'une des revendications 1 ou 2, **caractérisée en ce qu'**elle comporte une sous-couche enterrée de manière à créer un guide d'ondes élastiques (G_{Z2}) et constituant ladite seconde zone.

4. Structure acoustique selon la revendication 3, **caractérisée en ce qu'**elle comprend au moins une première électrode supérieure et une seconde électrode supérieure, la seconde zone comprenant des sous-couches périodiques définissant une structure enterrée de miroir de Bragg (MR), de manière à définir un résonateur à ondes de volume de type SMR.

5. Structure acoustique selon la revendication 1, **caractérisée en ce que** la seconde zone comprend des structures périodiques de manière à définir une structure de cristal phononique.

6. Structure acoustique selon l'une des revendications précédentes, **caractérisée en ce qu'**elle comporte en outre des électrodes supérieures (E_{S1}, E_{S2}) permettant de définir des structures de résonateurs couplés, séparés par une seconde zone de manière à optimiser le couplage entre lesdits résonateurs.

7. Structure acoustique selon la revendication 6, **caractérisée en ce qu'**elle comporte en outre également des troisièmes zones (Z₃) de troisième module d'Young et/ou de troisième densité comportant :
- des lacunes électroniques et/ou de défauts dans le matériau piézoélectrique ou ;
- la substitution d'une partie des atomes du matériau piézoélectrique par des atomes implantés ou ;
- des inclusions de taille nanométrique, différents de ceux du matériau comportant un premier ensemble d'atomes présentant un premier module d'Young dit intrinsèque et une première densité dite intrinsèque,
- en périphérie des deux résonateurs couplés de manière à diminuer plus fortement la propagation des ondes acoustiques latérales dans le matériau piézoélectrique dans lesdites troisièmes zones que dans lesdites secondes zones.

8. Structure acoustique selon l'une des revendications 1 à 6, **caractérisée en ce que** le matériau intrinsèque est du niobate de lithium LiNbO₃, la seconde zone comportant un matériau de type HₓLi₍₁₋ₓ₎NbO₃ présentant ledit second module d'Young.

9. Procédé de fabrication d'une structure acoustique comprenant une couche de matériau piézoélectrique (Z1) comportant un premier ensemble d'atomes présentant un premier module d'Young dit intrinsèque et une première densité dite intrinsèque et comprenant des électrodes situées à la surface de ladite couche de matériau piézoélectrique pour générer des ondes acoustiques dans ladite couche, le procédé comprenant :
- la réalisation d'un masque pour effectuer l'implantation et/ou la diffusion d'atomes de manière à définir une seconde zone ;
- l'implantation et/ou la diffusion d'atomes localement dans ladite couche , de manière à définir au moins une seconde zone (Z2, Z_{CP}) enterrée dans le volume de ladite couche de matériau, comprenant un second ensemble d'atomes comprenant ledit premier ensemble d'atomes plus des seconds atomes ou le second ensemble d'atomes comprenant ledit premier ensemble d'atomes dans lequel des seconds atomes sont en substitution de certains premiers atomes, et présentant un second module d'Young et /ou une seconde densité obtenus par l'implantation et/ou par la diffusion d'atomes dans le volume de ladite couche ;
- une étape de réalisation d'électrodes en contact avec la surface de ladite couche de matériau piézoélectrique (Z1) mais pas en contact avec la surface de ladite seconde zone (Z2, Z_{CP})
- la propagation d'ondes acoustiques dans ladite seconde zone (Z2, Z_{CP}), étant modifiée par rapport à la propagation des ondes dans ladite couche de matériau piézoélectrique (Z1) ;
- une étape de retrait dudit masque.

10. Procédé de fabrication d'une structure acoustique selon la revendication 9, **caractérisé en ce qu'**il comprend une étape de recuit postérieure à l'étape d'implantation et/ou diffusion d'atomes.

11. Procédé de fabrication d'une structure acoustique selon l'une des revendications 9 ou 10, **caractérisé en ce qu'**il comprend des opérations successives d'implantation et/ou diffusion d'atomes à des énergies proches de manière à créer une seconde zone continue d'implantation et/ou diffusion.

## Patentansprüche

1. Akustische Struktur, die Folgendes umfasst:
- eine piezoelektrische Materialschicht (Z1), die einen ersten Satz von Atomen aufweist, die ein erstes intrinsisches Young-Modul und eine erste intrinsische Dichte aufweisen;
- Elektroden, die mit der Oberfläche der piezoelektrischen Materialschicht in Kontakt sind, um eine akustische Wellenausbreitung an der Schicht zu erzeugen;
wobei die Schicht Folgendes umfasst:
wenigstens eine zweite Zone (Z2, Z_{CP}), die nicht mit den Elektroden in Kontakt ist:
o vergraben im Volumen der Materialschicht;
o umfassend einen zweiten Satz von Atomen, der den ersten Satz von Atomen plus zweite Atome umfasst, oder den zweiten Satz von Atomen, der den ersten Satz von Atomen umfasst, in dem die zweiten Atome bestimmte erste Atome ersetzen;
o mit einem zweiten Young-Modul und/oder einer zweiten Dichte, so dass die Ausbreitung der akustischen Wellen modifiziert wird.

2. Akustische Struktur nach Anspruch 1, **dadurch gekennzeichnet, dass** die zweite Zone Folgendes umfasst:
- elektronische Lücken und/oder Defekte in dem piezoelektrischen Material oder
- den Ersatz eines Teils der Atome des piezoelektrischen Material durch implantierte Atome oder
- Einschlüsse.

3. Akustische Struktur nach Anspruch 1 oder 2, **dadurch gekennzeichnet, dass** sie eine vergrabene Teilschicht umfasst, um einen elastischen Wellenleiter (G_{Z2}) zu erzeugen und die zweite Zone zu bilden.

4. Akustische Struktur nach Anspruch 3, **dadurch gekennzeichnet, dass** sie wenigstens eine erste obere Elektrode und eine zweite obere Elektrode umfasst, wobei die zweite Zone periodische Teilschichten umfasst, die eine vergrabene Bragg-Spiegelstruktur (MR) definiert, um einen Volumenwellenresonator des SMR-Typs zu definieren.

5. Akustische Struktur nach Anspruch 1, **dadurch gekennzeichnet, dass** die zweite Zone periodische Strukturen umfasst, um eine phononische Kristallstruktur zu definieren.

6. Akustische Struktur nach einem der vorherigen Ansprüche, **dadurch gekennzeichnet, dass** sie ferner obere Elektroden (E_{S1}, E_{S2}) umfasst, die es zulassen, gekoppelte Resonatorstrukturen zu definieren, getrennt durch eine zweite Zone, um die Kopplung zwischen den Resonatoren zu optimieren.

7. Akustische Struktur nach Anspruch 6, **dadurch gekennzeichnet, dass** sie ferner auch dritte Zonen (Z₃) mit drittem Young-Modul und/oder mit dritter Dichte umfasst, die Folgendes umfasst:
- elektronische Lücken und/oder Defekte in dem piezoelektrischen Material, oder
- den Ersatz eines Teils der Atome des piezoelektrischen Materials durch implantierte Atome, oder
- Einschlüsse von Nanometergröße, die sich von denen des Materials unterscheiden, umfassend einen ersten Satz von Atomen mit einem ersten intrinsischen Young-Modul und einer ersten intrinsischen Dichte,
- an der Peripherie von zwei gekoppelten Resonatoren, um die Ausbreitung von lateralen akustischen Wellen in dem piezoelektrischen Material in den dritten Zonen stärker zu verringern als in den zweiten Zonen.

8. Akustische Struktur nach einem der Ansprüche 1 bis 6, **dadurch gekennzeichnet, dass** das intrinsische Material Lithiumniobat LiNbO₃ ist, wobei die zweite Zone ein Material des Typs HₓLi₍₁₋ₓ₎NbO₃ umfasst, das das zweite Young-Modul aufweist.

9. Verfahren zur Herstellung einer akustischen Struktur, die eine piezoelektrische Materialschicht (Z1) umfasst, umfassend einen ersten Satz von Atomen mit einem ersten intrinsischen Young-Modul und einer ersten intrinsischen Dichte und mit Elektroden, die sich an der Oberfläche der piezoelektrischen Materialschicht befinden, um akustische Wellen in der Schicht zu erzeugen, wobei das Verfahren Folgendes beinhaltet:
- Realisieren einer Maske zum Bewirken der Implantation und/oder der Diffusion von Atomen, um eine zweite Zone zu definieren;
- lokales Implantieren und/oder Diffundieren von Atomen in der Schicht, um wenigstens eine zweite Zone (Z2, Z_{CP}) zu definieren, die in dem Volumen der Materialschicht vergraben ist, umfassend einen zweiten Satz von Atomen, der den ersten Satz von Atomen plus zweite Atome umfasst, oder den zweiten Satz von Atomen, umfassend den ersten Satz von Atomen, in dem die zweiten Atome bestimmte erste Atome ersetzen, oder mit einem zweiten Young-Modul und/oder einer zweiten Dichte, erhalten durch Implantieren und/oder Diffundieren von Atomen in dem Volumen der Schicht;
- einen Schritt des Realisierens von Elektroden in Kontakt mit der Oberfläche der piezoelektrischen Materialschicht (Z1), aber nicht in Kontakt mit der Oberfläche der zweiten Zone (Z2, Z_{CP}),
- wobei die Ausbreitung von akustischen Wellen in der zweiten Zone (Z2, Z_{CP}) mit Bezug auf die Ausbreitung der Wellen in der piezoelektrischen Materialschicht (Z1) modifiziert ist;
- einen Schritt des Entfernens der Maske.

10. Verfahren zur Herstellung einer akustischen Struktur nach Anspruch 9, **dadurch gekennzeichnet, dass** sie einen Glühschritt nach dem Schritt des Implantierens und/oder Diffundierens von Atomen beinhaltet.

11. Verfahren zur Herstellung einer akustischen Struktur nach Anspruch 9 oder 10, **dadurch gekennzeichnet, dass** sie aufeinander folgende Vorgänge des Implantierens und/oder Diffundierens von Atomen mit nahen Energien umfasst, um eine zweite kontinuierliche Implantations- und/oder Diffusionszone zu erzeugen.

## Claims

1. An acoustic structure comprising:
- a layer of piezoelectric material (Z1) comprising a first set of atoms having a first intrinsic Young's modulus and a first intrinsic density;
- electrodes placed in contact with the surface of said layer of piezoelectric material to generate an acoustic wave propagation at said layer;
said layer comprising:
at least one second zone (Z2, Z_{CP}) not in contact with said electrodes:
o buried in the volume of said layer of material;
o comprising a second set of atoms comprising said first set of atoms plus second atoms or the second set of atoms comprising said first set of atoms in which second atoms are substituted for certain first atoms;
o having a second Young's modulus and/or a second density such that it modifies the propagation of said acoustic waves.

2. The acoustic structure according to claim 1, **characterized in that** said second zone comprises:
- electronic deficiencies and / or defects in the piezoelectric material or;
- the substitution of a part of the atoms of the piezoelectric material by implanted atoms or;
- inclusions.

3. The acoustic structure according to one of claims 1 or 2, **characterized in that** it comprises a buried underlayer so as to create an elastic waveguide (G_{z2}) and constituting said second zone.

4. The acoustic structure as claimed in claim 3, **characterized in that** it comprises at least a first upper electrode and a second upper electrode, the second zone comprising periodic sub-layers defining a buried structure of Bragg mirror (MR), so as to define a volume wave resonator of the SMR type.

5. The acoustic structure according to claim 1, **characterized in that** the second zone comprises periodic structures so as to define a phononic crystal structure.

6. The acoustic structure according to one of the preceding claims, **characterized in that** it further comprises upper electrodes (E_{S1}, E_{S2}) for defining coupled resonator structures, separated by a second zone so as to optimize the coupling between said resonators.

7. The acoustic structure according to claim 6, **characterized in that** it furthermore comprises third zones (Z₃) of third Young's modulus and/or third density comprising:
- electronic deficiencies and/or defects in the piezoelectric material or;
- the substitution of a part of the atoms of the piezoelectric material by implanted atoms or;
- inclusions of nanometric size, different from those of the material comprising a first set of atoms presenting a first intrinsic Young's modulus and a first intrinsic density,
- on the periphery of the two coupled resonators so as to decrease the propagation of side acoustic waves in the piezoelectric material more strongly in said third zones than in said second zones.

8. The acoustic structure according to one of claims 1 to 6, **characterized in that** the intrinsic material is lithium niobate LiNbO₃, the second zone comprising a material of the type HₓLi₍₁₋ₓ₎NbO₃ having said second Young's modulus.

9. A process for manufacturing an acoustic structure comprising a layer of piezoelectric material (Z1) comprising a first set of atoms presenting a first intrinsic Young's module and a first intrinsic density and including electrodes located on the surface of said layer of piezoelectric material for generating acoustic waves in said layer, the method comprising:
- producing a mask to perform the implantation and/or diffusion of atoms so as to define a second zone;
- implanting and/or diffusing atoms locally in said layer, so as to define at least a second zone (Z2, Z_{CP}) buried in the volume of said layer of material, comprising a second set of atoms comprising said first set of atoms plus second atoms or the second set of atoms comprising said first set of atoms in which second atoms are substituted for certain first atoms, and presenting a second Young's module and/or a second density obtained by implanting and/or diffusing atoms in the volume of said layer;
- a step of producing electrodes in contact with the surface of said layer of piezoelectric material (Z1) but not in contact with the surface of said second zone (Z2, Z_{CP})
- the propagation of acoustic waves in said second zone (Z2, Z_{CP}) being modified with respect to wave propagation in said piezoelectric material layer (Z1);
- a step of removing said mask.

10. The process for manufacturing an acoustic structure according to claim 9, **characterized in that** it comprises an annealing step after the step of implanting and/or diffusing atoms.

11. The process for manufacturing an acoustic structure according to one of claims 9 or 10, **characterized in that** it comprises successive operations of implanting and/or diffusing atoms at similar energies so as to create a second continuous implantation and/or diffusion zone.
